# EUROPEAN PATENT APPLICATION

(11) **EP 3 007 340 A1**
(43) Date of publication of application: **13.04.2016**
(21) Application number: 15161464.1
(22) Date of filing: 27.03.2015
(51) Int. Cl.: H02M 1/44, H02M 3/00

(54) **SQUARE WAVE GENERATOR TO DITHER CARRIER FREQUENCY IN SWITCHED DC/DC CONVERTER**

(30) Priority: 10.10.2014 KR 20140136640
(71) Applicant: Hyundai Motor Company, Seoul 137-938 (KR); Kia Motors Corporation, Seoul 137-938 (KR)
(72) Inventor: Na, Jung Hwan, 445-330 Gyeonggi-do (KR); Jeong, Jee Hye, 431-764 Gyeonggi-do (KR); Lee, Jae Won, 445-788 Gyeonggi-do (KR); Chung, Tae Hwan, 405-757 Incheon (KR)
(74) Representative: Isarpatent

(57) **Abstract**

An apparatus for generating a switching signal for an analog controller (50) includes: a voltage setting unit (10) configured to set voltages V_{ref_high} and V_{ref_low} of a triangular wave; a period adjuster (20) configured to adjust a period of the triangular wave; a triangular wave generator (30) configured to generate the triangular wave at the period based on the voltages set by the voltage setting unit; and an AC component passing unit (40) configured to pass an AC component of the triangular wave through a low voltage DC-DC converter (LDC) analog controller (50).

## Description

### CROSS-REFERENCE TO RELATED APPLICATION

This application claims the benefit of and priority to Korean Patent Application No. 10-2014-0136640, filed on October 10, 2014 in the Korean Intellectual Property Office, the disclosure of which is incorporated herein in its entirety by reference.

### TECHNICAL FIELD

The present disclosure relates to an apparatus for generating a switching signal for an analog controller, and more particularly, to an apparatus for generating a switching signal which is used in an analog pulse width modulation controller of a low DC-DC converter (LDC) for a hybrid vehicle or an electric vehicle.

### BACKGROUND

Recently, efforts have been made with hybrid or electric vehicles to meet current the demands for improvement in fuel efficiency. As a result, development of more environmentally-friendly products has been increasing.

Generally, a hybrid vehicle refers to a vehicle driven by efficiently combining two different kinds of power sources. In particular, a hybrid vehicle is typically driven by an engine (i.e., internal combustion engine) obtaining a torque by combusting fuel (i.e., fossil fuel, such as gasoline) and an electric motor obtaining a torque by battery power.

The hybrid vehicle or the electric vehicle is equipped with an auxiliary battery which supplies driving power to electric components of the vehicle along with a main battery which provides driving power of an electric motor (i.e., driving motor), in which the auxiliary battery is connected to a low voltage DC-DC converter (LDC or LVDCDC, hereinafter, referred to as LDC) for output conversion between a high voltage and a low voltage. As is well-known in the art, the LDC in hybrid or electric vehicles is an apparatus serving as an alternator of the vehicle. To this point, the LDC supplies an electric field load of 12 V, converts a high DC voltage from a high voltage battery into a low DC voltage, and charges the converted low DC voltage in the auxiliary battery.

Existing LDC analog controllers generate a fixed switching frequency (for example, 100 kHz) using values of a resistor RT and a capacitor CT, based on an oscillator equipped therein and control the LDC depending on the generated switching frequency. Therefore, noise is generated due to high speed switching, thereby causing radio frequency interference (RFI). Further, the existing LDC analog controller needs an expensive filter to remove the high-speed switching noise.

### SUMMARY

The present disclosure has been made to solve the above-mentioned problems occurring in the related art while advantages achieved by the related art are maintained intact.

An aspect of the present disclosure provides an apparatus for generating a switching signal for an analog controller to allow an analog pulse width modulation (PWM) controller of a low DC-DC converter (LDC) for a hybrid or electric vehicle to have a frequency spreading range corresponding to preset voltages V_{ref_high} and V_{ref_low} and a modulation rate corresponding to a preset period, by generating a triangular wave as a switching signal at the preset voltages

V_{ref_high} and V_{ref_low} and the preset period.

According to embodiments of the present disclosure, an apparatus for generating a switching signal for an analog controller, includes: a voltage setting unit configured to set voltages V_{ref_high} and V_{ref_low} of a triangular wave; a period adjuster configured to adjust a period of the triangular wave; a triangular wave generator configured to generate the triangular wave at the period based on the voltages set by the voltage setting unit; and an AC component passing unit configured to pass an AC component of the triangular wave through a low voltage DC-DC converter (LDC) analog controller.

The AC component passing unit may pass through only the AC component of the triangular wave independent of an offset.

The AC component passing unit may include a capacitor and a resistor.

The voltages may determine a spreading range of a switching frequency of the LDC analog controller.

The period may determine a modulation rate of the LDC analog controller.

The foregoing and other objects, features, aspects and advantages of the present disclosure will be understood and become more apparent from the following detailed description of the present disclosure. Also, it can be easily understood that the objects and advantages of the present disclosure can be realized by the units and combinations thereof recited in the claims.

### BRIEF DESCRIPTION OF THE DRAWINGS

The above and other objects, features and advantages of the present disclosure will be more apparent from the following detailed description taken in conjunction with the accompanying drawings.
FIG. 1 is a configuration diagram of an apparatus for generating a switching signal for an analog controller according to embodiments of the present disclosure;
FIG. 2 is a circuit diagram of an apparatus for generating a switching signal for an analog controller according to embodiments of the present disclosure;
FIG. 3 is an exemplified diagram of a frequency spreading phenomenon in an LDC analog controller according to embodiments of the present disclosure;
FIG. 4 is an exemplified diagram of a triangular wave generated by the apparatus for generating a switching signal for an analog controller according to embodiments of the present disclosure;
FIG. 5 is an exemplified diagram of an output waveform of an LDC analog controller to which embodiments of the present disclosure are applied;
FIG. 6A is an exemplified diagram illustrating an improvement effect of an electromagnetic wave generated by the apparatus for generating a switching signal for an analog controller according to embodiments of the present disclosure; and
FIG. 6B is another exemplified diagram illustrating an improvement effect of an electromagnetic wave generated by the apparatus for generating a switching signal for an analog controller according to embodiments of the present disclosure.

### DETAILED DESCRIPTION

Hereinafter, embodiments of the present disclosure will be described in detail with reference to the accompanying drawings.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

It is understood that the term "vehicle" or "vehicular" or other similar term as used herein is inclusive of motor vehicles in general such as passenger automobiles including sports utility vehicles (SUV), buses, trucks, various commercial vehicles, watercraft including a variety of boats and ships, aircraft, and the like, and includes hybrid vehicles, electric vehicles, plug-in hybrid electric vehicles, hydrogen-powered vehicles and other alternative fuel vehicles (e.g., fuels derived from resources other than petroleum). As referred to herein, a hybrid vehicle is a vehicle that has two or more sources of power, for example both gasoline-powered and electric-powered vehicles.

Additionally, it is understood that one or more of the below methods, or aspects thereof, may be executed by at least one controller. The term "controller" may refer to a hardware device that includes a memory and a processor. The memory is configured to store program instructions, and the processor is specifically programmed to execute the program instructions to perform one or more processes which are described further below. Moreover, it is understood that the below processes may be executed by an apparatus comprising the controller in conjunction with other components.

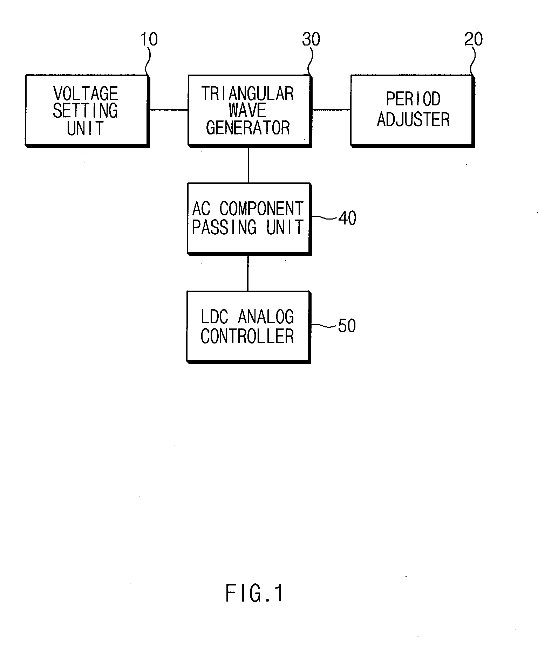

FIG. 1 is a configuration diagram of an apparatus for generating a switching signal for an analog controller according to embodiments of the present disclosure. As illustrated in FIG. 1, the apparatus for generating a switching signal for an analog controller according to embodiments of the present disclosure includes a voltage setting unit 10, a period adjuster 20, a triangular wave generator 30, an alternating current (AC) component passing unit 40, and an LDC analog controller 50.

Describing each component, first, the voltage setting unit 10 sets voltages V_{ref_high} and V_{ref_low} of a triangular wave. That is, the voltage setting unit 10 sets a maximum voltage V_{ref_high} and a minimum voltage V_{ref_low} of the triangular wave. Next, the period adjuster 20 adjusts a generation period of the triangular wave which is generated by the triangular wave generator 30. That is, the period adjuster 20 controls the triangular wave generator 30 to generate the triangular wave at a preset period. Next, the triangular wave generator 30 generates the triangular wave at a period set by the period adjuster 20 based on the voltage set by the voltage setting unit 10.

Next, the AC component passing unit 40 passes through the AC component of the triangular wave generated by the triangular wave generator 30 and blocks a direct current (DC) component. That is, the AC component passing unit 40 transfers the AC component of the triangular wave generated by the triangular wave generator 30 to the LDC analog controller 50 and does not transfer the DC component of the triangular wave to the LDC analog controller 50. That is, the AC component passing unit 40 passes through only the AC component of the triangular wave independent of an offset.

Next, the LDC analog controller 50 controls the LDC based on the AC component of the triangular wave passing through the AC component passing unit 40. In this case, the voltage set by the voltage setting unit 10 corresponds to a spreading range of a switching frequency of the LDC analog controller 50 (the spreading range is determined depending on the voltage) and the period adjusted by the period adjuster 20 corresponds to the modulation rate of the LDC analog controller 50 (the modulation rate is determined depending on the period). Because the LDC analog controller 50 controls the LDC based on a current, the spreading phenomenon occurs.

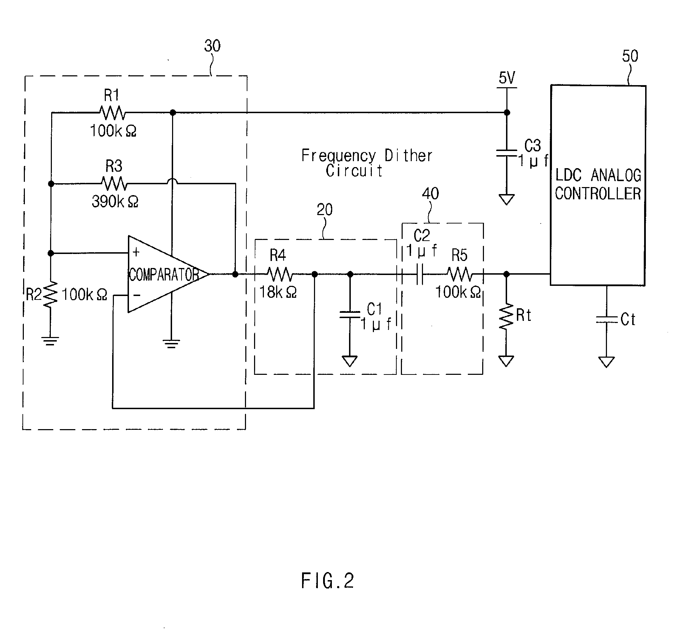

FIG. 2 is a circuit diagram of an apparatus for generating a switching signal for an analog controller according to embodiments of the present disclosure. As illustrated in FIG. 2, the AC component passing unit 40, the period adjuster 20, and the triangular wave generator 30 are sequentially connected to an Rt terminal of the LDC analog controller 50. In this configuration, the AC component passing unit 40 has a simple structure of a capacitor and a resistor to block the DC component of the triangular wave and pass through only the AC component.

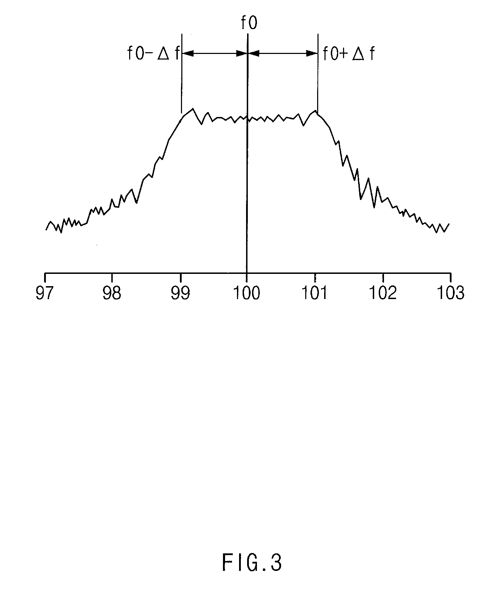

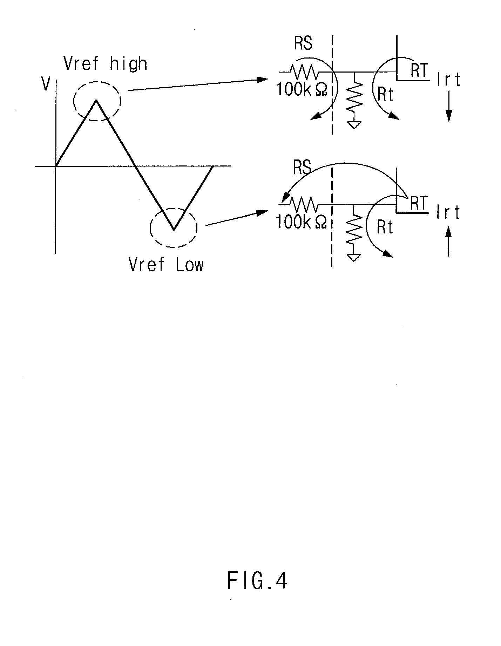

As illustrated in FIG. 3, the frequency spreading phenomenon occurs in the LDC analog controller 50 receiving the AC component of the triangular wave passing through the AC component passing unit 40. In this case, the frequency spreading range is determined by a voltage range of the triangular wave and the frequency spreading range f0 ± Δf has a reference frequency (100 kHz) ± 10%. Hereinafter, the triangular wave generated by a circuit for generating a triangular wave will be described in more detail with reference to FIG. 4.

As illustrated in FIG. 4, the voltage range corresponding to the frequency range is 3 V and the modulation rate corresponds to the period. Here, an arrow represents a current direction, and when a current represents a difference value, the voltage is 2.78 V as the maximum value V_{ref_high} and when the current is branched, the voltage is 2.22 V as the minimum value V_{lef_low}. In this case, the maximum value and the minimum value may be calculated based on the following Table 1.

**[Table 1]**

| | | |
|---|---|---|
| V(Ref_High) | 2.78V | 5×R2/{(R1 ∥ R3)+R2} |
| V(Ref_Low) | 2.22V | 5×(R1 ∥ R3)/{(R1 ∥ R2)+R2} |

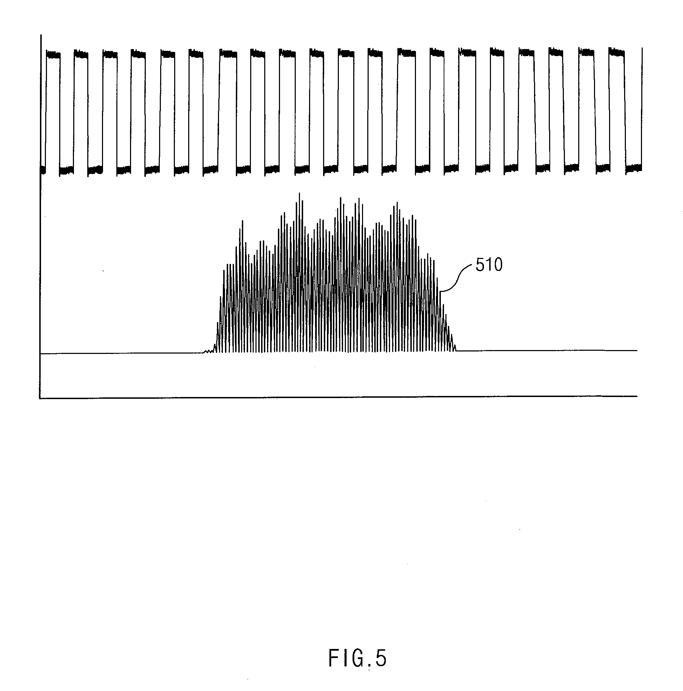

FIG. 5 is an exemplified diagram of an output waveform of an LDC analog controller to which the embodiments of the present disclosure are applied. An output waveform of FIG. 5 is a signal of which the frequency is spread by the triangular wave generated by the apparatus for generating a switching signal according to embodiments of the present disclosure, in which a frequency modulation rate of the triangular wave is 5.12 ms, a frequency spreading range is 570 mV, and a frequency fluctuation range 510 is 215.4 kHz which is increased by 9.8% from 196.1 kHz and is 174.4 kHZ which is reduced by 11.1% from 196.1 kHz. Here, the frequency fluctuation range is a frequency distribution diagram, in which the larger the frequency range, the wider the spreading width.

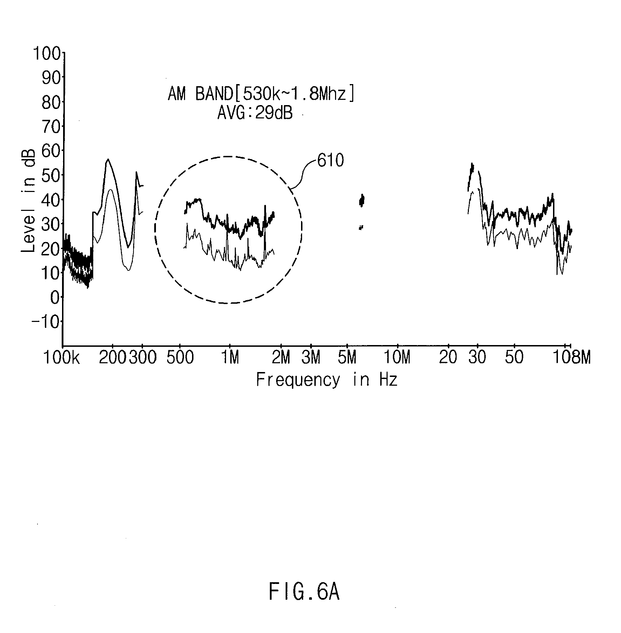

FIG. 6A is an exemplified diagram illustrating an improvement effect of an electromagnetic wave generated by the apparatus for generating a switching signal for an analog controller according to embodiments of the present disclosure. FIG. 6A is a graph illustrating an electromagnetic wave measured at a low voltage output terminal (low voltage +), in which the a circular dotted line portion 610 in an AM band (530 kHz to 1.8 MHz) represents 29dB in average, which is a value reduced by 10 dB or more, as compared with the case in which the apparatus for generating a switching signal according to embodiments of the present disclosure is not applied.

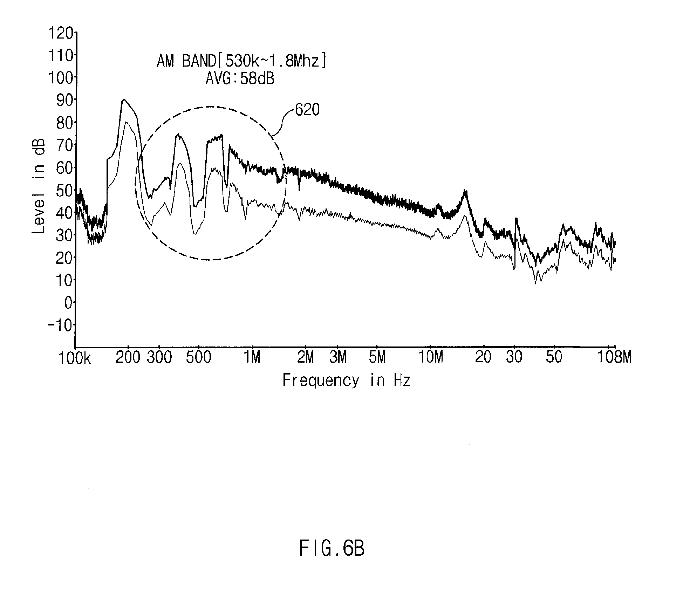

FIG. 6B is another exemplified diagram illustrating an improvement effect of an electromagnetic wave generated by the apparatus for generating a switching signal for an analog controller according to embodiments of the present disclosure. FIG. 6B is a graph illustrating an electromagnetic wave measured at an LDC output terminal, in which the a circular dotted line portion 620 in an AM band (530 kHz to 1.8 MHz) represents 58 dB in average, which is a value reduced by 10 dB or more, as compared with the case in which the apparatus for generating a switching signal according to embodiments of the present disclosure is not applied.

As set forth above, according to embodiments of the present disclosure, it is possible to allow the analog pulse width modulation (PWM) controller of the LDC for the hybrid vehicle or the electric vehicle to have the frequency spreading range corresponding to the preset voltages V_{ref_high} and V_{ref_low} and the modulation rate corresponding to the preset period, by generating the triangular wave as the switching signal at the preset voltages V_{ref_high} and V_{lef_low} and the preset period. Further, it is possible to reduce the noise due to the high speed switching by allowing the analog PWM controller of the LDC for the hybrid vehicle or the electric vehicle to have the frequency spreading range corresponding to the preset voltages and the modulation rate corresponding to the preset period. Further, according to embodiments of the present disclosure, it is possible to remove the radio frequency interference (RFI) by reducing noise due to the high speed switching.

The present disclosure described above may be variously substituted, altered, and modified by those skilled in the art to which the present disclosure pertains without departing from the scope and sprit of the present disclosure. Therefore, the present disclosure is not limited to the above-mentioned embodiments and the accompanying drawings.

### SYMBOL OF EACH OF THE ELEMENTS IN THE FIGURES

- 10:: VOLTAGE SETTING UNIT
- 20:: PERIOD ADJUSTER
- 30:: TRIANGULAR WAVE GENERATOR
- 40:: AC COMPONENT PASSING UNIT
- 50:: LDC ANALOG CONTROLLER

## Claims

1. An apparatus for generating a switching signal for an analog controller, comprising:
a voltage setting unit configured to set voltages V_{ref_high} and V_{lef_low} of a triangular wave;
a period adjuster configured to adjust a period of the triangular wave;
a triangular wave generator configured to generate the triangular wave at the period based on the voltages set by the voltage setting unit; and
an AC component passing unit configured to pass an AC component of the triangular wave through a low voltage DC-DC converter (LDC) analog controller.

2. The apparatus according to claim 1, wherein the AC component passing unit passes through only the AC component of the triangular wave independent of an offset.

3. The apparatus according to claim 1, wherein the AC component passing unit includes a capacitor and a resistor.

4. The apparatus according to claim 1, wherein the voltages determine a spreading range of a switching frequency of the LDC analog controller.

5. The apparatus according to claim 1, wherein the period determines a modulation rate of the LDC analog controller.
